# EUROPÄISCHE PATENTSCHRIFT

(11) **EP 2 577 756 B1**
(45) Veröffentlichungstag und Bekanntmachung des Hinweises auf die Patenterteilung: **29.04.2015**
(21) Anmeldenummer: 11722360.2
(22) Anmeldetag: 12.05.2011
(51) Int. Cl.: H01L 35/32

(54) **THERMOELEKTRISCHES ELEMENT**
THERMOELECTRIC ELEMENT
ÉLÉMENT THERMOÉLECTRIQUE

(30) Priorität: 04.06.2010 DE 102010022668
(43) Veröffentlichungstag der Anmeldung: 10.04.2013
(73) Patentinhaber: O-Flexx Technologies GmbH, 47059 Duisburg (DE)
(72) Erfinder: SPAN, Gerhard, A-6112 Wattens (AT)
(74) Vertreter: Kohlmann, Kai
(86) Internationale Anmeldenummer: PCT/EP2011/057679
(87) Internationale Veröffentlichungsnummer: WO 2011/151144

(56) Entgegenhaltungen:
- EP-A2- 1 102 333
- EP-A2- 1 976 034

## Beschreibung

Die Erfindung betrifft ein Thermcelektrisches Element mit mindestens einem Thermopaar, das einen n-dotierten und einen p-dotierten Thermoschenkel aus Halbleitermaterial aufweist, wobei sich die Thermoschenkel zwischen einer heißen und einer kalten Seite des thermoelektrischen Elementes erstrecken und unterschiedlich hohe Temperaturen zwischen der heißen und der kalten Seite anlegbar bzw. abgreifbar sind und das thermoelektrische Element einen Träger umfasst, wobei der Träger einen ersten Trägerteil und einen zweiten Trägerteil mit hoher Wärmeleitfähigkeit aufweist, das erste und zweite Trägerteil durch einen Abschnitt mit einer gegenüber den Trägerteilen geringeren Wärmeleitfähigkeit voneinander getrennt sind, die auf dem Träger angeordneten Thermoschenkel sich zwischen dem ersten und dem zweiten Trägerteil erstrecken und den Abschnitt mit der geringeren wärmeleitfähigkeit überbrücken, wobei einer der Trägerteile die heiße und der andere Trägerteil die kalte Seite des thermoelektrischen Elemente bilden.

Die Wirkungsweise thermoelektrischer Elemente beruht auf dem thermoelektrischen Effekt:

Beim Seebeck-Effekt entsteht zwischen zwei Punkten eines elektrischen Leiters bzw. Halbleiters, die eine verschiedene Temperatur haben, eine elektrische Spannung. Während der Seebeck-Effekt das Entstehen einer Spannung beschreibt, tritt der Peltier-Effekt ausschließlich durch das Fließen eines äußeren Stromes auf. In einem stromdurchflossenen Thermopaar treten immer beide Effekte auf. Der Peltier-Effekt tritt auf, wenn zwei Leiter oder Halbleiter mit unterschiedlichen elektronischen Wärmekapazitäten in Kontakt gebracht werden und durch einen von außen angelegten elektrischen Strom Elektronen aus dem einen Leiter / Halbleiter in den anderen fließen. Mit geeigneten Materialien, insbesondere Halbleiter-Materialien, gelingt es, mit elektrischem Strom Temperaturdifferenzen zu erzeugen oder umgekehrt aus Temperaturdifferenzen elektrischen Strom zu erzeugen.

Die direkte Wandlung von wärme in elektrische Energie ist mit einem thermoelektrischen Generator mit mehreren thermoelektrischen Elementen möglich. Die thermoelektrischen Elemente bestehen vorzugsweise aus unterschiedlich dotierten Halbleitermaterialien, wodurch sich die Effizienz gegenüber Thermoelementen mit zwei unterschiedlichen und an einem Ende miteinander verbundenen Metallen, wesentlich steigern lässt.. Gebräuchliche Halbleitermaterialien sind Bi2Te3, PbTe, SiGe, BiSb oder FeSi2. Um ausreichend hohe Spannungen zu erhalten, werden mehrere thermoelektrische Elemente zu einem Modul zusammengefasst und elektrisch in Reihe und ggf. aucr. parallel geschaltet.

Ein herkömmliches thermoelektrisches Element besteht aus zwei oder mehreren kleinen Quadern aus p- und n-dotiertem Halbleitermaterial, die abwechselnd oben und unten durch Metallbrücken miteinander verbunden sind. Die Metallbrücken bilden zugleich die thermischen Kontaktflächen auf einer heißen bzw. kalten Seite des thermoelektrischen Elementes und sind zumeist zwischen zwei im Abstand zueinander angeordneten Keramikplatten angeordnet. Jeweils ein n-dotierter und ein p-dotierter Quader, auch als Thermoschenkel bezeichnet, bilden ein Thermopaar, wobei sich die Quader zwischen der heißen und der kalten Seite des thermoelektrischen Elementes erstrecken. Die unterschiedlich dotierten Quader sind durch die Metallbrücken so miteinander verbunden, dass sie eine Reihenschaltung ergeben.

Sofern den Quadern ein elektrischer Stron zugeführt wird, kühlen sich abhängig von der stromstärke und Stromrichtung die Verbindungsstellen der Quader auf der einen Seite ab, während sie sich auf der gegenüberliegenden Seite erwärmen.

Der angelegte Strom erzeugt damit eine Temperaturdifferenz zwischen den Keramikplatten. Wird indessen eine unterschiedlich hohe Temperatur an den gegenüberliegenden Keramikplatten angelegt, wird abhängig von der Temperaturdifferenz ein Stromfluss in den Quadern des thermoelektrischen Elementes hervorgerufen.

Die Kantenlänge der Quader in sämtlichen Richtungen betragen etwa 1 - 3 mm. Die Form der Quader ist annähernd an einen Würfel angenähert. Die erhebliche Dicke der Quader ist erforderlich, da diese nicht nur zur Erzielung des thermoelektrischen Effektes dienen, sondern darüber hinaus für die mechanische Stabilität des thermoelektrischen Elementes sorgen. Insbesondere stützen sich auf den als Verbindungsstellen dienenden Metallbrücken die Keramikplatten auf der heißen bzw. kalten Seite des thermoelektrischen Elementes ab. Die Quader benötigen daher viel Halbleitermaterial, das zur Erzielung des thermoelektrischen Effektes nicht erforderlich ist. In Folge dessen ist die elektrische und thermische Leistungsdichte bezogen auf die Masse bekannter thermoelektrischer Elemente relativ gering, obwohl die thermische Leistungsdichte bezogen auf die Fläche der thermoelektrischen Module für die meisten Anwendungen zu gross ist.

Die US 2007/0152352 A1 offenbart eine thermoelektrische Vorrichtung mit mehreren Thermopaaren, die jeweils aus einem n-dotierten Thermoschenkel und einem p-dotierten Thermoschenkel aus Halbleitermaterial bestehen. Die thermoelektrische Vorrichtung umfasst eine rahmenförmige Tragstruktur, die eine Öffnung umgibt. In dieser Öffnung der Tragstruktur ist ein Substrat angeordnet. Das Substrat dient der Aufnahme einer elektronischen Einheit, deren Temperatur gezielt über oder unterhalb der Umgebungstemperatur mit Hilfe der thermoelektrischen Vorrichtung gehalten werden soll. Zwischen diesem Substrat und der das Substrat umgebenden Tragstruktur befindet sich eine thermisch isolierende Struktur, auf der die Thermoschenkel sämtlicher Thermopaare ausschließlich angeordnet sind. Während des Betriebs der thermoelektrischen Vorrichtung fließt Strom durch die in Reihe geschalteten Thermopaare. Der Stromfluss bewirkt, dass thermische Energie von dem Substrat zu der Tragstruktur durch die thermisch isolierende Struktur übertragen wird, wodurch das Substrat und die darauf angeordnete elektronische Einheit gekühlt werden.

Die EP 1 976 034 A2 offenbart einen thermoelektrischen Chip mit mehreren Thermopaaren, die jeweils einen n-dotierten und einen p-dotierten Dünnschicht-Thermoschenkel aus Halbleitermaterial und eine metallische Verbindung zwischen den Thermoschenkeln aufweisen. Die Thermoschenkel erstrecken sich zwischen einer heißen und einer kalten Seite des thernoelektrischen Chips. Das thermoelektrische Element umfasst einen Träger aus hoch wärmeleitendem Material mit einem ersten Trägerteil und einen zweiten Trägerteil, wobei das erste und zweite Trägerteil durch einen Abschnitt mit einer gegenüber den Trägerteilen geringeren Wärmeleitfähigkeit voneinander getrennt sind. Die Dünnschicht-Thermoschenkel und die metallischen Verbindungen zwischen den Thermoschenkeln sind auf einer nach außen weisenden Oberfläche einer Membran aus elektrisch isolierendem Material angeordnet. Die andere, gegenüberliegende Oberfläche der Membran liegt randseitig auf den Trägerteilen auf, so dass sich die Membran von dem ersten zum zweiten Trägerteil erstreckt und die auf der nach außen weisenden Oberfläche der Membran angeordneten Thermoschenkel den Abschnitt mit der geringeren Wärmeleitfähigkeit überbrücken. Mindestens ein Chip, vorzugsweise mehre Chips werden zu Einheiten zwischen einer Platte an der heißen und einer Platte an der kalten Seite zusammengefasst.

Ausgehend von diesem Stand der Technik liegt der Erfindung die Aufgabe zu Grunde, ein thermoelektrisches Element mit hoher thermischer Leistungsdichte bezogen auf die Masse zu schaffen, bei dem die Anordnung der Thermoschenkel auf dem Träger und deren Kontaktierung untereinander vereinfacht ist. Die absolute thermische Leistung und Leistungsdichte der thermoelektrischen Elemente sowie der daraus hergestellten Module soll gut an die bei deren Anwendung anfallenden thermischen Leistungen und Leistungsdichten angepasst werden können.

Im Einzelnen wird die Aufgabe bei einem thermoelektrischen Element der eingangs erwähnten Art dadurch gelöst, dass die Thermoschenkel auf einem Substrat mit geringer Wärmeleitfähigkeit aufgebracht sind und das Substrat mit seiner die Thermoschenkel aufweisenden Oberfläche auf dem Träger angeordnet ist. In dem die Durchgänge überbrückenden Bereich übernimmt das Substrat die Tragfunktion zur die Thermoschenkel der Thermopaare. Das Substrat kann beispielsweise aus Glas bestehen, dass eine Wärmeleitfähigkeit von 0,76 W/m*K aufweist.

Insbesondere wenn der Abschnitt mit geringerer Wärmeleitfähigkeit teilweise Durchgänge aufweist, wird die Anordnung der Thermoschenkel auf dem Träger durch das Substrat erleichtert.

Der Träger kann aus preiswerterem und gegenüber dem Halbleitermaterial mechanisch stabilerem Material bestehen, so dass die Träger bei gleicher mechanischer Stabilität einen geringeren Bauraum benötigen. Der vorzugsweise als Quader ausgeführte Träger kann bei Verwendung stabilerer Materialien beispielsweise eine geringere Dicke aufweisen, als die herkömmlichen Halbleiter-Quader.

Die Thermoschenkel des Thermopaars sind vorzugsweise als Schicht, insbesondere als Dünnschicht oder als Folie auf dem Träger angeordnet. Es wird daher wesentlich weniger Halbleitermaterial als bei herkömmlichen thermoelektrischen Elementen benötigt.

Um die Temperaturdifferenz zwischen heißer und kalter Seite des thermoelektrischen Elementes in erster Linie in den Thermopaaren wirksam werden zu lassen, sind das erste und zweite Trägerteil durch den Abschnitt mit geringerer Wärmeleitfähigkeit voneinander getrennt. Die Thermoschenkel der Thermopaare erstrecken sich zwischen dem ersten und dem zweiten Trägerteil und überbrücken den Abschnitt mit geringerer Wärmeleitfähigkeit.

Der Abschnitt mit geringerer Wärmeleitfähigkeit entkoppelt die beiden Trägerteile thermisch, so dass der eine Trägerteil die heiße und der andere Trägerteil die kalte Seite des thermoelektrischen Elementes bilden.

Der die beiden Trägerteile trennende Abschnitt kann vollständig oder teilweise aus einem Dämmstoff bestehen. Sofern der trennende Abschnitt nur teilweise aus dem Dämmstoff besteht, wird der verbleibende Teil des Abschnitts zwischen erstem und zweitem Trägerteil durch das Ungebungsgas, insbesondere die Umgebungsluft gebildet, die eine geringe Wärmeleitfähigkeit von 0,0261 W/m*K aufweist.

Eine andere Möglichkeit die Wärmeleitfähigkeit in dem Abschnitt zwischen den beiden Trägerteilen zu reduzieren besteht darin, dass die beiden Trägerteile durch mindestens einen Steg miteinander verbunden sind. Der im Verhältnis zu den Tragertellen geringe Querschnitt der Stege bildet einen Wärmewiderstand und setzt damit in dem Abschnitt die Wärmeleitfähigkeit herab. Produktionstechnisch vorteilhaft befinden sich die insbesondere quaderförmigen Stege bei einem quaderförmigen Träger etwa mittig an zwei gegenüberliegenden Flächen des Quaders. In dem zwischen den Stegen befindlichen, ebenfalls quaderförmigen Durchgang befindet sich ein Gas, insbesondere die Umgebungsluft, mit gegenüber den ersten und zweiten Trägerteil geringerer Wärmeleitfähigkeit.

Eine noch wirksamere thermische Entkopplung zwischen dem ersten und zweiten Trägerteil wird erreicht, wenn der Steg bzw. die verbindenden Stege aus einem Material mit geringerer Wärmeleitfähigkeit als die Trägerteile bestehen. Zu der verminderten Wärmeleitfähigkeit des Abschnitts infolge des reduzierten Querschnitts der Stege kommt dann noch die materialbedingte Herabsetzung der Wärmeleitfähigkeit hinzu.

Wie bei herkömmlichen thermoelektrischen Elementen sind die unterschiedlich dotierten Thermoschenkel in Reihe geschaltet. Um den elektrischen Anschlusswiderstand zu reduzieren, sind die in Reihe geschalteten Thermoschenkel auf der kalten Seite mit den beiden elektrischen Kontakten verbunden. Die Kontakte sind vorzugsweise als Kontaktbereiche auf der Oberfläche des Trägerteils angeordnet oder in dessen Oberfläche eingebettet.

Um eine Vielzahl erfindungsgemäßer thermoelektrischer Elemente miteinander elektrisch zu verschalten, insbesondere diese in einem Modul zusammen zu fassen, weist vorzugsweise einer der beiden Kontakte auf der kalten Seite eine Durchkontaktierung auf, die zu einem Kontakt auf der gegenüberliegenden Seite des Trägerteils führt. Der Kontakt auf der gegenüberliegenden Seite kann ebenfalls auf der Oberfläche des Trägerteils aufgebracht oder in dessen Oberfläche eingelassen sein.

Als Materialien für den Träger bzw. das erste und zweite Tragerteil kommen insbesondere Werkstoffe der technischen Keramik in Betracht. Die keramischen Werkstoffe weisen die geforderte hohe Wärmeleitfähigkeit bei gleichzeitig guter elektrischer Isolierfähigkeit auf, die zur Vermeidung von Kurzschlüssen zwischen den in Reihe geschalteten Thermopaaren erforderlich ist. Des Weiteren sind keramische Werkstoffe hoch temperaturfest und weisen die für thermoelektrische Elemente wünschenswerte Temperatur-Wechselbeständigkeit auf. Für die Tragfunktion ist die Festigkeit, Härte und Formbeständigkeit von keramischen Werkstoffen vorteilhaft. Die Korrosions- und Verschleißfestigkeit keramischer Werkstoffe tragen dem Wunsch nach dauerhaltbaren thermoelektrischen Elementen Rechnung.

Der keramische Träger, insbesondere das erste und zweite Trägerteil bestehen vorzugsweise aus einer Mehrlagen-Niedextemperatur-Einbrand-Keramik. Niedertemperatur-Einbrand-Keramiken (Low Temperature Cofired Ceramics (LTCC)) basieren auf einer Technologie zur Herstellung von mehrlagigen Keramikträgern. Zunächst wird keramisches Pulver zusammen mit Lösungsmitteln und Plastifikatoren zu Folien verarbeitet. Die ungebrannten Folien werden durch Stanzen, Schneiden und ggf. Bedrucken strukturiert. Zur Herstellung von Durchkontaktierungen werden beispielsweise Durchgangslöcher in die Keramikfolien gestanzt oder mit dem Laser geschnitten.

Die einzelnen Lagen der strukturierten Keramikfolie werden ausgerichtet und in einer Pressform gestapelt. Die Durchgangslöcher werden mit einer Leitpaste, insbesondere Silber-, Silber/Palladium- oder Goldpaste gefüllt. Der Vorteil dieser Leitpasten besteht darin, dass sie beim anschließenden Brennen in nahezu gleichem Maße wie die Keramikfolien schrumpfen. Unter Zufuhr von Wärme, beispielsweise 70 Grad Celsius und Druck, zum Beispiel 90 bar, werden die Keramikfolien laminiert. Beim Anschließenden Brennen der Keramikfolien verbinden sich die einzelnen Lagen der Keramikfolien fest miteinander.

Um die Wärmeleitfähigkeit zu verbessern, können in die Mehrlagen-Niedertemperatur-Einbrand-Keramik Lagen zur Verbesserung der Wärmeleitfähigkeit der Trägerteile eingebettet werden. Als Lagen kommen insbesondere Metallisierungslagen, jedoch auch Lagen aus Silizium, Alluminiumnitrit oder Alluminiumoxid in Betracht. Die Lagen aus Aluminiumnitrit und Aluminiumoxid verbessern die Wärmeleitfähigkeit, sind jedoch elektrisch isolierend. Sie kommen daher insbesondere auf der heißen Seite des thermoelektrischen Elementes zum Einsatz. Die Verbindung zwischen den eingebetteten Lagen und den Keramikfolien erfolgt beispielsweise mittels Reaktivlot bzw. Glaslot. Die Wärmeleitfähigkeit kann zusätzlich durch Durchgänge verbessert werden, die wie die Durchkontaktierungen mit metallischen Werkstoffen gefüllt sind.

Um die elektrische Ausgangsleistung zu steigern, können mehrere thermoelektrische Elemente gemäß der Erfindung elektrisch und mechanisch in einem Modul miteinander verbunden werden. Vorzugsweise sind die das Modul bildenden, thermoelektrischen Elemente als plattenförmige Quader ausgebildet, die zu einem Stapel zusammengefasst sind. Jedes thermoelektrische Element des Moduls weist vorzugsweise Kontaktierungen auf den gegenüberliegenden Seiten des plattenförmigen Trägerteils auf der kalten Seite auf, die mit den Kontaktierungen des jeweils angrenzenden plattenförmigen thermoelektrischen Elementes in Beruhrung gelangen, so dass die thermoelaktrischen Elemente des Moduls in Reihe oder parallel geschaltet sind.

Nachfolgend wird die Erfindung anhand der Figuren näher erläutert. Es zeigen:
- **Figur 1**: auf einem Substrat als Schicht ausgebildete Thermopaare für ein erfindungsgemäßes thermoelektrisches Element,
- **Figur 2a**: eine Vorder- und Seitenansicht eines Trägers des thermoelektrischen Elementes,
- **Figur 2b**: eine Rückansicht des Trägers des erfindungsgemäßen thermoelektrischen Elementes,
- **Figur 2c**: eine Aufsicht auf das erfindungsgemäße thermoelektrische Element,
- **Figur 3**: eine schematische perspektivische Ansicht eines zweiten Ausführungsbeispieles eines thermoelektrischen Elementes, bei dem die Thermoschenkel auf einer Seite des Trägers angeordnet sind,
- **Figur 4**: eine schematische perspektivische Ansicht eines dritten Ausführungsbeispieles eines thermoelektrischen Elementes, bei dem die Thermoschenkel auf zwei gegenüberliegenden Seiten des Trägers angeordnet sind,
- **Figur 5**: ein thermoelektrisches Element nach Figur 4 mit verbesserter thermischer Leitfähigkeit,
- **Figur 6**: mehrere thermoelektrische Elemente, die zu einem Stapel zusammengefasst sind sowie
- **Figur 7**: eine Möglichkeit zur Anordnung mehrerer thermoelektrischer Elemente zwischen zwei im Abstand zueinander angeordneten keramischen Platten, um ein Modul aufzubauen.

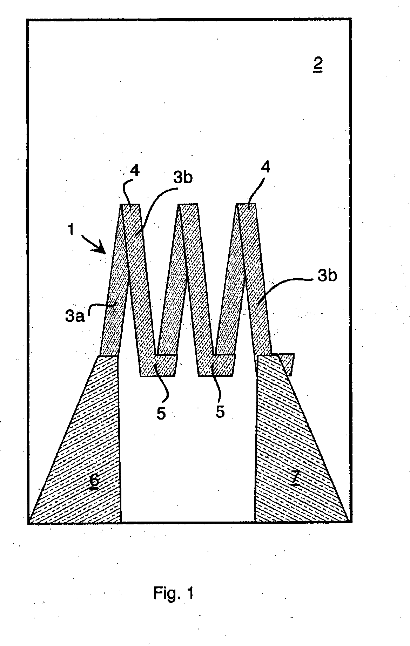

Figur 1 zeigt drei Thermopaare (1), die auf einem Substrat (2) als Schicht aufgebracht sind. Das Substrat (2) ist beispielsweise eine rechteckige Glasplatte, die eine geringe Wärmeleitfähigkeit aufweist. Jedes Thermopaar (1) umfasst einen n-dotierten Thermoschenkel (3a) und einen p-dotierten Thermoschenkel (3b) aus einem Halbleitermaterial. Die n- und p-dotierten Thermoschenkel (3a, b) sind an gegenüberliegenden Verbindungsstellen (4, 5) elektrisch in Reihe geschaltet.

Die Reihenschaltung der n- und p-dotierten Thermoschenkel (3 a, b) ist an ihrem Ein- und Ausgang mit zwei elektrischen Kontakten (6, 7) verbunden, die als Kontaktbereiche auf der Oberfläche des Substrats (2) als metallische Schicht aufgebracht sind.

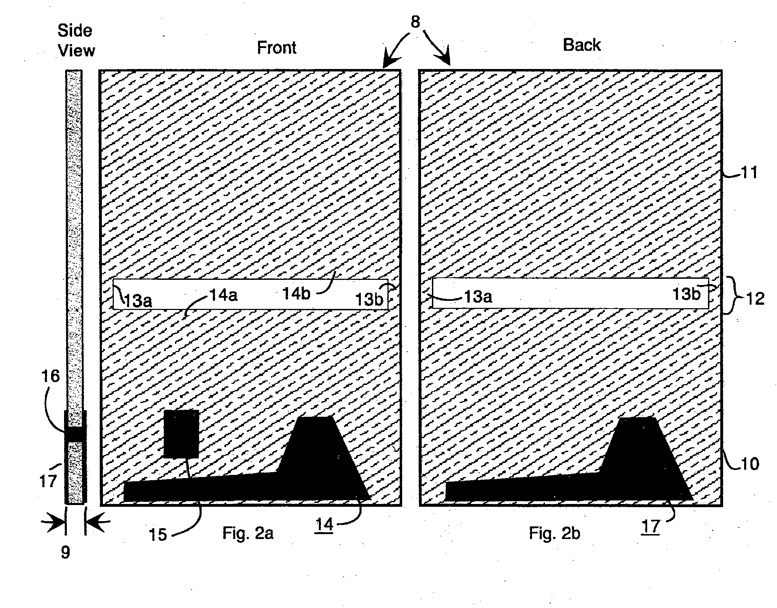

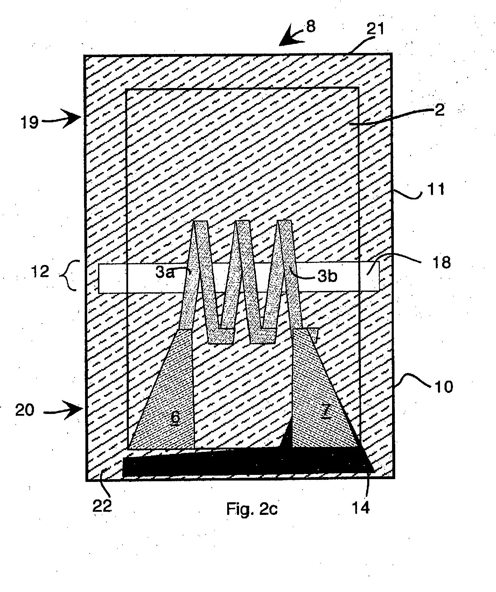

Die Figuren 2 a, 2 b zeigen einen Träger (8) des erfindungsgemäßen thermoelektrischen Elementes. Der Träger (8) weist insgesamt die Form eines Quaders auf. Aus der in Figur 2 a dargestellten Seitenansicht ist erkennbar, dass dessen Dicke (9) aufgrund der Trennung von Tragfunktion und thermoelektrischem Effekt relativ gering ist. Der Träger (8) umfasst ein erstes Trägerteil (10) und ein zweites Trägerteil (11) mit hoher Wärmeleitfähigkeit. Die Trägerteile bestehen vorzugsweise aus einem technischen Keramik-Werkstoff. Die beiden Trägerteile (10, 11) sind durch einen Abschnitt (12) mit einer gegenüber den Trägerteilen geringeren Wärmeleitfähigkeit voneinander getrennt. Der Abschnitt (12) weist zwei das erste und zweite Trägerteil (10, 11) verbindende Stege (13 a, b) auf, die in Verlängerung der Seitenflächen die beiden Trägerteile (10, 11) miteinander verbinden. Sofern die Stege (13 a, b) aus demselben Material wie die Trägerteile (10, 11) bestehen, ist die Wärmeleitfähigkeit aufgrund des geringeren Querschnitts der Stege (13a, b) gegenüber dem Querschnitt der Trägerteile (10, 11) deutlich reduziert. Der Abschnitt (12) weist darüber hinaus den durch die Stege (13 a, b) seitlich und die Stirnflächen (14 a, b) des ersten und zweiten Trägerteils (10, 11) begrenzten Spalt auf, der Umgebungsluft enthält, die eine gegenüber den Trägerteilen (10, 11) geringere Wärmeleitfähigkeit aufweist und diese daher thermisch entkoppelt.

Auf der Vorderseite des Tragers (8) befinden sich als Kontaktbereiche ausgebildete Kontakte (14, 15) zur elektrischen Kontaktierung der in Reihe geschalteten Thermopaare (1). Der Kontakt (15) ist über eine Durchkontaktierung (16) mit einem Kontakt (17) auf der Rückseite des Trägers (8) elektrisch leitend verbunden. Die großflächigen Kontakte (14, 17) auf der Vorder- und Rückseite des ersten Trägerteils (10) des Trägers (8) erlauben es, dass thermoelektrisch Element einfach zu kontaktieren und mit weiteren, gleichartigen thermoelektrischen Elementen zu verschalten.

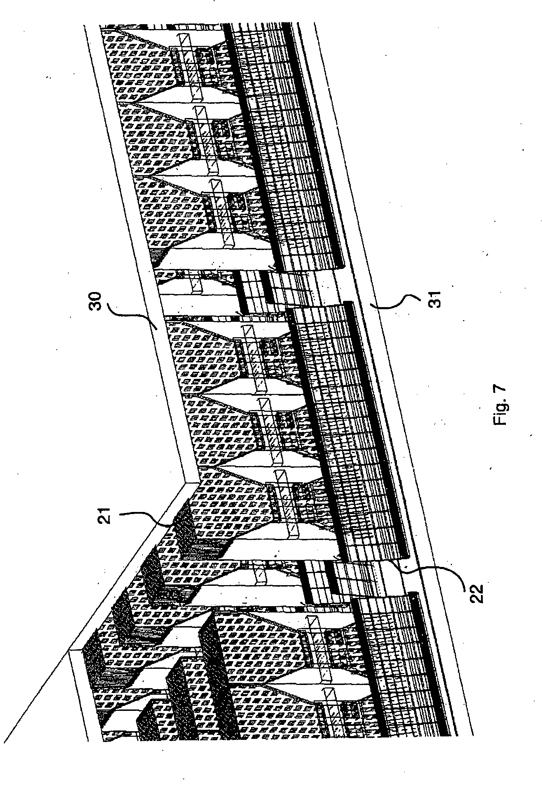

Figur 2 c veranschaulicht, wie das Substrat (2) mit der die Thermoschenkel (3 a, b) aufweisenden Oberfläche auf dem Träger (8) angeordnet wird. Die Kontakte (6, 7) gelangen auf der Oberseite des Trägers (8) mit den Kontakten (14, 15) in Berührung, so dass der Kontakt (6) über die Durchkontaktierung (16) mit dem rückseitigen Kontakt (17) verbunden ist. Die Thermoschenkel (3 a, b) der Thermopaare (1) erstrecken sich zwischen dem ersten und dem zweiten Trägerteil (10, 11) und überbrücken dabei den Luftspalt (18) des Abschnitts (12) mit geringerer Wärmeleitfähigkeit. Das zweite Trägerteil (11) bildet die heiße (19) und das erste Trägerteil (10) die kalte Seite (20) des thermoelektrischen Elementes. Die Einkopplung der Wärme erfolgt insbesondere am oberen Rand (21) des zweiten Trägerteils (11), während eine Wärmesenke am unteren Rand (22) des ersten Trägerteils (10) angeordnet ist. Wie bei herkömmlichen thermoelektrischen Elementen können eine Vielzahl der thermoelektrischen Elemente mit ihrem oberen und unteren Rand (21, 22) zwischen senkrecht zur Bildebene verlaufenden Keramikplatten (30, 31) angeordnet sein, wie dies in Figur 7 dargestellt ist. Die mechanische Stabilität des Trägers (8) reicht aus, um die keramischen Platten (30, 31) trotz thermoelektrischer Dünnschichttechnologie auf Abstand zu halten.

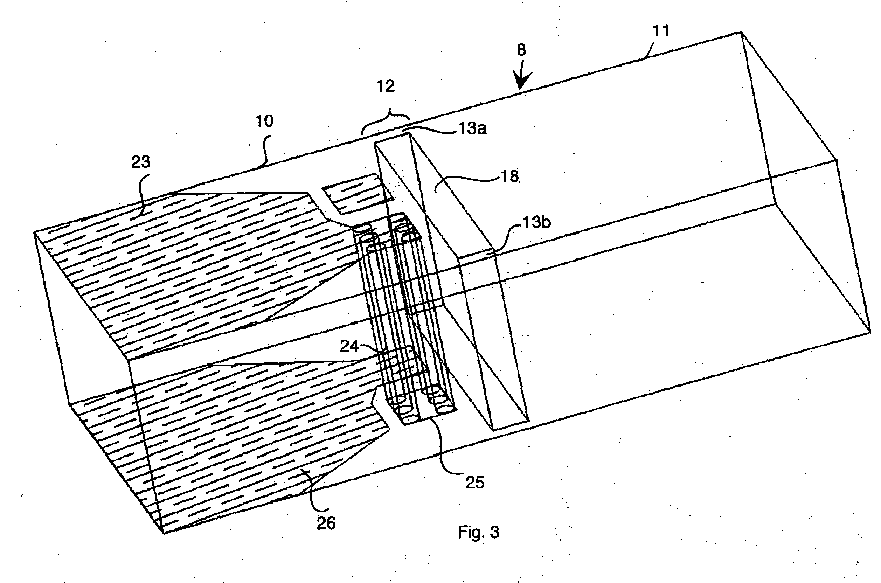

Figur 3 zeigt einen keramischen Träger (8), bei dem das erste und zweite Trägerteil (10, 11) sowie die Stege (13a, b) des Abschnitts (12) aus einer Mehrlagen-Niedertemperatur-Einbrand-Keramik bestehen. Auf der nach oben zeigenden Vorderseite des Trägers (8) befindet sich ein Kontakt (23), der über eine Durchkontaktierung (24) mit einem Kontakt (25) auf der Rückseite des Trägers (8) verbunden ist. Des Weiteren befindet sich auf der Rückseite ein großflächiger Kontakt (26) der, wie auch der Kontakt (25), zum Anschluss der in Reihe geschalteten Thermoschenkel (3 a, b) bestimmt ist. Die in Reihe geschalteten Thermoschenkel (3 a, b) sind auf der Rückseite mit den beiden Kontakten (25, 26) verbunden und erstrecken sich von dem ersten Trägerteil (10) auf der kalten Seite zum zweiten Trägerteil (11) auf der heißen Seite, wobei sie den Luftspalt (18) des Abschnitts (12) überbrücken. Die Thermoschenkel (3 a, b) sind vorzugsweise auf einem Substrat angeordnet. Alternativ können die Thermoschenkel Bestandteil einer Folie sein, die aufgrund ihrer Eigensteifigkeit ohne zusätzliches Substrat den Luftspalt (18) überbrücken kann.

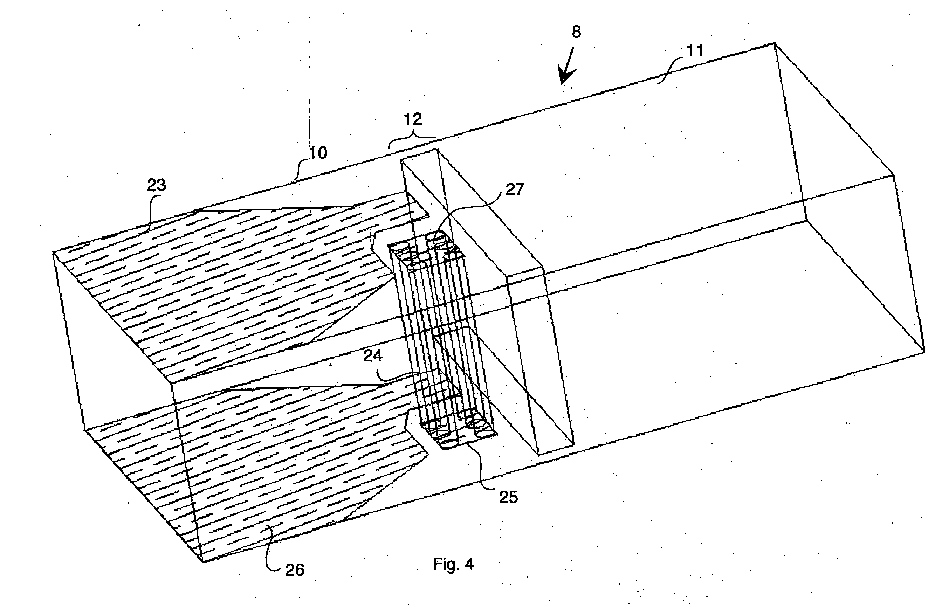

Figur 4 zeigt einen Träger (8) auf dessen Vorder- und Rückseite die Thermoschenkel (3 a, b) mehrerer Thermopaare (1) angeordnet sind. Samtliche Thermoschenkel (3 a, b) sind in Reihe geschaltet. Der Träger (8) weist auf der Oberseite den Kontakt (23) und den Kontakt (27) auf, eine von dem Kontakt (27) ausgehende Durchkontaktierung (24), die mit einen Kontakt (25) auf der Rückseite verbunden ist, sowie den rückseitigen Kontakt (26).

Die in Reihe geschalteten Thermoschenkel (3 a, b) auf der Oberseite des Trägers (8) sind endseitig mit den Kontakten (23, 27) verbunden. Auf der Unterseite sind die in Reihe geschalteten Thermoschenkel (3 a, b) mit den elektrischen Kontakten (25, 26) verbunden, wobei die Durchkcntaktierung (24) die elektrisch leitende Verbindung zwischen den Thermoschenkeln (3a, b) auf der Ober- und Unterseite des Trägers (8) herstellt.

In gleicher Weise wie bei dem Träger nach Figur 3 lassen sich mehrere thermoelektrische Elementen über die großflächigen Kontakte (23, 26) in Reihe oder auch Parallel schalten.

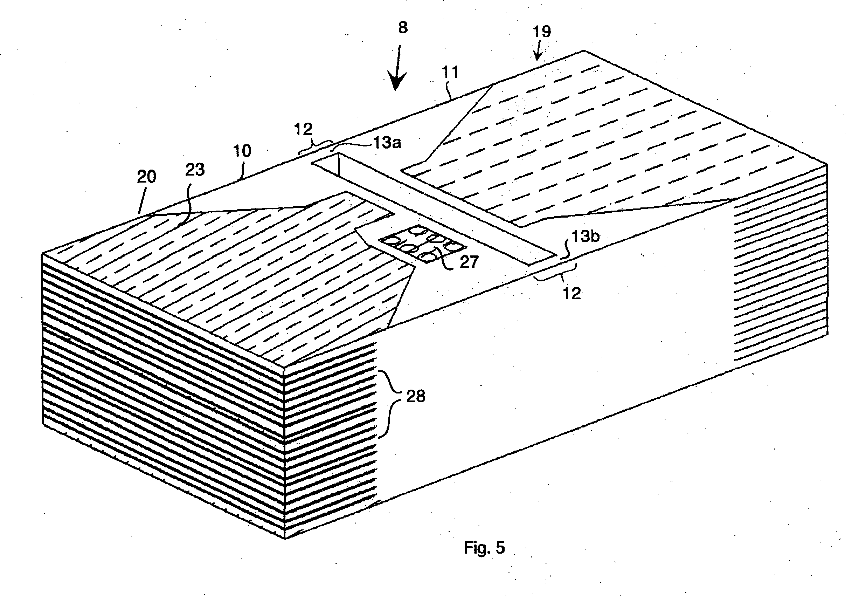

Der Träger nach Figur 5 entspricht hinsichtlich der Kontaktierung der Thermoschenkel (3 a, b) dem Träger nach Figur 4, so dass auf die dortigen Ausführungen vollumfänglich verwiesen wird. Durch Einbettung von Metallisierungslagen (28) ist jedoch die thermische Leitfähigkeit sowohl auf der heißen als auch kalten Seite (19, 20) des Trägers (8) verbessert. Auf der heißen Seite (19) ist die Ober- und Unterseite des Trägers (8) frei von Metallisierungen, damit es nicht zu Kurzschlüssen zwischen den auf der Ober- und Unterseite aufliegenden Thermoschenkeln (3a, b) kommt. Alternativ können auf der heißen Seite Lagen aus Silizium, Aluminiumnitrit oder Aluminiumoxid in das zweite Trägerteil (10) eingebettet werden, um die Wärmeleitfähigkeit zu verbessern, jedoch Kurzschlüsse zwischen den Thermoschenkeln (3 a, b) zu vermeiden.

Auch auf der kalten Seite (20) ist darauf zu achten, dass keine Metallisierungen auf der Unter- bzw. Oberseite Kurzschlüsse zwischen den Thermoschenkeln (3 a, b) außerhalb der Kontaktbereiche (23, 25, 26, 27) verursachen. Aus Figur 5 ist weiter erkennbar, dass der Abschnitt (12) mit geringerer Wärmeleitfähigkeit frei von Metallisierungen ist. Die Wärmeleitfähigkeit der Stege (13a, b) wird folglich nicht nur durch den geringeren Querschnitt, sondern darüber hinaus durch die fehlende Metallisierung herabgesetzt.

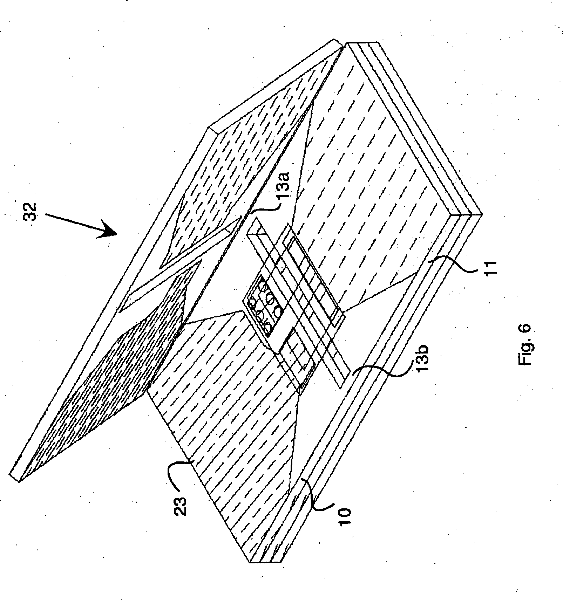

Figur 6 offenbart schließlich einen Stapel (32) umfassend mehrere elektrisch in Reihe geschaltete thermoelektrische Elemente, die entsprechend Figur 3 aufgebaut sind, jedoch eine geringere Dicke aufweisen. Mehrere derartige Stapel (32) können zu einem Modul (29) entsprechend Figur 7 zusammengefasst werden.

**Bezugszeichenliste**

| **Nr.** | **Bezeichnung** | **Nr.** | **Bezeichnung** |
|---|---|---|---|
| 1 | Thermopaar | 29 | Modul |
| 2 | Substrat | 30 | erste Keramikplatten |
| 3 a | n-dotierter Thermoschenkeln | 31 | zweite Keramikplatte |
| 3 b | p-dotierter Thermoschenkel | 32 | Stapel |
| 4 | Verbindungsstelle | | |
| 5 | Verbindunqsstelle | | |
| 6 | Kontakt | | |
| 7 | Kontakt | | |
| 8 | Träger | | |
| 9 | Dicke Träger | | |
| 10 | erstes Trägerteil | | |
| 11 | zweites Trägerteil | | |
| 12 | Abschnitt | | |
| 13 a, b | Stege | | |
| 14 | Kontakt | | |
| 15 | Kontakt | | |
| 16 | Durchkontaktierung | | |
| 17 | Kontakt | | |
| 18 | Luftspalt | | |
| 19 | heiße Seite | | |
| 20 | kalte Seite | | |
| 21 | oberer Rand | | |
| 22 | unterer Rand | | |
| 23 | Kontakt | | |
| 24 | Durchkontaktierung | | |
| 25 | Kontakt | | |
| 26 | Kontakt | | |
| 27 | Kontakt | | |
| 28 | Metallisierungslagen | | |

## Patentansprüche

1. Thermoelektrisches Element mit mindestens einem Thermopaar (1), das einen n-dotierten und einen p-dotierten Thermoschenkel (3a, 3b) aus Halbleitermaterial aufweist, wobei sich die Thermoschenkel (3a, 3b) zwischen einer heißen und einer kalten Seite (19, 20) des thermoelektrischen Elementes erstrecken, unterschiedlich hohe Temperaturen zwischen der heißen und der kalten Seite (19, 20) anlegbar bzw. abgreifbar sind und das thermoelektrische Element einen Träger (8) unfasst, wobei
(a) der Träger (8) einen ersten Trägerteil (10) und einen zweiten Trägerteil (11) mit hoher Wärmeleitfähigkeit aufweist,
(b) das erste und zweite Trägerteil (10, 11) durch einen Abschnitt (12) mit einer gegenüber den Trägerteilen (10, 11) geringeren Wärmeleitfähigkeit voreinander getrennt sind,
(c) die auf dem Träger (8) angeordneten Thermoschenkel (3a, b) sich zwischen dem ersten und dem zweiten Trägerteil (10, 11) erstrecken und den Abschnitt (12) mit der geringeren Wärmeleitfähigkeit überbrücken, wobei einer der Tragerteile (11) die heiße und der andere Trägerteil (10) die kalte Seite des thermoelektrischen Elementes bilden,
**dadurch gekennzeichnet, dass**
(d) die Thermoschenkel (3a, b) auf einem Substrat (2) mit geringer Wärmeleitfähigkeit aufgebracht sind und
(e) das Substrat (2) mit der die Thermoschenkel (3a, b) aufweisenden Oberfläche auf dem Träger (8) aufliegt.

2. Thermoelektrisches Element nach Anspruch 1, **dadurch gekennzeichnet, dass** die Thermoschenkel (3a, b) als Schicht ausgebildet sind.

3. Thermoelektrisches Element nach Anspruch 1, **dadurch gekennzeichnet, dass** die Thermoschenkel (3a, b) als Folie ausgebildet sind.

4. Thermoelektrisches Element nach einem der Ansprüche 1 bis 3, **dadurch gekennzeichnet, dass** der Abschnitt (12) mindestens einen das erste und zweite Trägerteil verbindenden Steg (13a, b) umfasst.

5. Thermoelektrisches Element nach einem der Ansprüche 1 bis 4, **dadurch gekennzeichnet, dass** der Abschnitt (12) mit der geringeren Wärmeleitfähigkeit zumindest teilweise aus einem Dämmstoff besteht.

6. Thermoelektrisches Element nach einem der Ansprüche 1 bis 5, **dadurch gekennzeichnet, dass** die in Reihe geschalteten Thermoschenkel (3a, b) auf der kalten Seite (20) mit mindestens zwei elektrischen Kontakten (14, 15) verbunden sind.

7. Thermoelektrisches Element nach einem der Ansprüche 1 bis 6, **dadurch gekennzeichnet, dass** einer der beiden Kontakte (15) mit einer Durchkontaktierung (16) verbunden ist, die zu einem Kontakt (17) auf einer dem Kontakt (15) gegenüberliegenden Seite des Trägerteils (10) führt.

8. Thermoelektrisches Element nach einem der Ansprüche 1 bis 7, **dadurch gekennzeichnet, dass** zumindest das erste und zweite Trägerteil (10, 11) aus Keramik bestehen.

9. Thermoelektrisches Element nach Anspruch 8, **dadurch gekennzeichnet, dass** zumindest das erste und zweite Trägerteil (10, 11) aus einer Mehrlagen-Niedertemperatur-Einbrand-Keramik bestehen.

10. Thermoelektrisches Element nach einem der Ansprüche 1 bis 9, **dadurch gekennzeichnet, dass** in das erste und zweite Trägerteil (10, 11) Lagen (28) zur Verbesserung der Wärmeleitfähigkeit der Trägerteile eingebettet sind.

11. Modul (29) umfassend mehrere elektrisch miteinander verbundene thermoelektrische Elemente nach einem der Ansprüche 1 bis 10.

12. Modul nach Anspruch 11, **dadurch gekennzeichnet, dass** die plattenförmigen thermoelektrischen Elemente einen Stapel bilden.

## Claims

1. A thermoelectric element, comprising at least one thermocouple (1) which has an n-doped and a p-doped thermocouple leg (3a, 3b) made from semiconductor material, wherein the thermocouple legs (3a, 3b) extend between a hot and a cold side (19, 20) of the thermoelectric element, different temperatures can be applied to or tapped off between the hot and the cold sides (19, 20), and the thermoelectric element has a carrier (8) wherein
(a) the carrier (8) has a first carrier part (10) and a second carrier part (11) having high thermal conductivity,
(b) the first and second carrier parts (10, 11) are separated from one another by a section (12) having a lower thermal conductivity compared to the carrier parts (10, 11),
(c) the thermocouple legs (3a, b) arranged on the carrier (8) extend between the first and the second carrier parts (10, 11), and bridge the section (12) having the lower thermal conductivity, wherein one of the carrier parts (11) forms the hot side and the other carrier part (10) forms the cold side of the thermoelectric element,
**characterized in that**
(d) the thermocouple legs (3a, b) are applied to a substrate (2) having low thermal conductivity and
(e) the surface of the substrate (2) having the thermocouple legs (3a, b) rests on the carrier (8).

2. The thermoelectric element according to claim 1, **characterized in that** the thermocouple legs (3a, b) are configured as a layer.

3. The thermoelectric element according to claim 1, **characterized in that** the thermocouple legs (3a, b) are configured as a film.

4. The thermoelectric element according to any one of claims 1 to 3, **characterized in that** the section (12) comprises at least one web (13a, b) connecting the first and second carrier parts.

5. The thermoelectric element according to any one of claims 1 to 4, **characterized in that** the section (12) having the lower conductivity consists at least partially of an insulating material.

6. The thermoelectric element according to any one of claims 1 to 5, **characterized in that** the thermocouple legs (3a, b) connected in series on the cold side (20) are connected to at least two electrical contacts (14, 15).

7. The thermoelectric element according to any one of claims 1 to 6, **characterized in that** one of the two contacts (15) is connected to a via (16) which leads to a contact (17) on a side of the carrier part (10) opposite to the contact (15).

8. The thermoelectric element according to any one of claims 1 to 7, **characterized in that** at least the first and second carrier parts (10, 11) consist of ceramic.

9. The thermoelectric element according to claim 8, **characterized in that** at least the first and second carrier part (10, 11) consist of a multilayer low-temperature co-fired ceramic.

10. The thermoelectric element according to any one of claims 1 to 9, **characterized in that** layers (28) for improving the thermal conductivity of the carrier parts are embedded in the first and second carrier parts (10, 11).

11. A module (29) comprising a plurality of thermoelectric elements according to any one of claims 1 to 10 which are electrically connected to one another.

12. The module according to claim 11, **characterized in that** the plate-shaped thermoelectric elements form a stack.

## Revendications

1. Thermocouple avec au moins un couple (1) qui comporte une branche thermoélectrique (3a) n-dopée et une branche thermoélectrique p-dopée (3b) en matière semiconductrice, les branches thermoélectriques (3a, 3b) s'étendant entre un côté chaud (19) et un côté froid (20) du thermocouple, des températures différentes pouvant être appliquées ou prélevées entre le côté chaud (19) et le côté froid (20) et le thermocouple comprenant un support (8),
(a) le support (8) comportant une première partie de support (10) et une deuxième partie de support (11) à conductivité thermique élevée,
(b) la première et la deuxième partie de support (10, 11) étant séparées l'une de l'autre par une section (12) faisant preuve d'une conductivité thermique plus faible par rapport aux parties de support (10, 11),
(c) les branches thermoélectriques (3a, b) placées sur le support (8) s'étendant entre la première et la deuxième partie de support (10, 11) et chevauchant la section (12) faisant preuve d'une conductivité thermique plus faible, l'une des parties de support (11) formant le côté chaud et l'autre partie de support (10) formant le côté froid du thermocouple,
**caractérisé en ce que**
(d) les branches thermoélectriques (3a, b) sont appliquées sur un substrat (2) faisant preuve d'une faible conductivité thermique et
(e) le substrat (2) repose par la surface comportant les branches thermoélectriques (3a, b) sur le support (8).

2. Thermocouple selon la revendication 1, **caractérisé en ce que** les branches thermoélectriques (3a, b) sont conçues en tant que couche.

3. Thermocouple selon la revendication 1, **caractérisé en ce que** les branches thermoélectriques (3a, b) sont conçues en tant que film.

4. Thermocouple selon l'une quelconque des revendications 1 à 3, **caractérisé en ce que** la section (12) comprend au moins un listel (13a, b) reliant la première et la deuxième partie de support.

5. Thermocouple selon l'une quelconque des revendications 1 à 4, **caractérisé en ce que** la section (12) faisant preuve d'une conductivité électrique plus faible est constituée au moins en partie en une matière isolante.

6. Thermocouple selon l'une quelconque des revendications 1 à 5, **caractérisé en ce que** les branches thermoélectriques (3a, b) couplées en série sont reliées sur le côté froid (20) avec au moins deux contacts (14, 15) électriques.

7. Thermocouple selon l'une quelconque des revendications 1 à 6, **caractérisé en ce que** l'un (15) des deux contacts est relié avec une métallisation des trous (16) qui génère un contact (17) sur un côté de la partie de support (10) opposée au contact (15).

8. Thermocouple selon l'une quelconque des revendications 1 à 7, **caractérisé en ce qu'**au moins la première et la deuxième partie de support (10, 11) sont constituées de céramique.

9. Thermocouple selon la revendication 8, **caractérisé en ce qu'**au moins la première et la deuxième partie de support (10, 11) sont constituées d'une céramique multicouches cofrittée à basse température.

10. Thermocouple selon l'une quelconque des revendications 1 à 9, **caractérisé en ce que** dans la première et dans la deuxième partie de support (10, 11) sont incorporées des couches (28) pour améliorer la conductivité thermique des parties de support.

11. Module (29) comprenant plusieurs thermocouples selon l'une quelconque des revendications 1 à 10 électriquement reliés ensemble.

12. Module selon la revendication 11, **caractérisé en ce que** les thermocouples en forme de plaques forment une pile.
